# EUROPEAN PATENT SPECIFICATION

(11) **EP 0 643 448 B1**
(45) Date of publication and mention of the grant of the patent: **22.07.1998**
(21) Application number: 94203024.8
(22) Date of filing: 17.04.1989
(51) Int. Cl.: H01R 17/12, H01R 23/68, H01R 23/70

(54) **Coaxial connector for connection to a printed circuit board**
Koaxialverbinder zur Verbindung mit Leiterplatten
Connecteur coaxial pour la connexion de plaquettes de circuits imprimés

(43) Date of publication of application: 15.03.1995
(62) Divisional of application: 89200986.1
(73) Proprietor: CONNECTOR SYSTEMS TECHNOLOGY N.V., Willemstad, Curaçao (AN); BERG ELECTRONICS MANUFACTURING B.V., 5222 AV's-Hertogenbosch (NL)
(72) Inventor: Verhoeven, Laurentius Maria, NL-5465 RV Veghel (NL)
(74) Representative: de Bruijn, Leendert C.

(56) References cited:
- DE-A- 3 620 111
- US-A- 3 426 311
- US-A- 3 689 865
- US-A- 3 958 852
- US-A- 4 698 906

## Description

This invention relates to a coaxial connector comprising at least one outermost and one innermost contact socket or pin, mutually electrically insulated and surrounded by a housing, and having connecting portions of electrically conducting material for connecting the coaxial connector to a printed circuit board, the outermost contact socket being electrically connected to an outer connecting portion for connecting it to said printed circuit board and the innermost contact socket or pin having an inner connecting portion for connecting it to said printed circuit board.

Such a coaxial connector is known from the German patent application 3.620.111, which comprises an additional contact case inserted into the outermost contact socket in order to establish good electrical and mechanical contact. The additional contact case is provided with two contact strips extending from the case and suitable to be soldered to contact pads on a predetermined side or a printed circuit board. The innermost contact socket is provided with an inner contact strip extending beyond the case and suitable to be soldered to the same predetermined side of the printed circuit board.

United States patent 3.958.852 describes a connector having one side that can be connected to several coaxial plugs of coaxial cables and one side that can be connected to a printed circuit board or the like. This connector therefore serves as an intermediate between coaxial cables and a printed circuit board or the like. The side of the connector to be connected to the circuit board or the like is provided with an inner conductor and an outer conductor between which the printed circuit board can be inserted, both the inner and the outer conductor being arranged to establish good electrical and mechanical contact with predetermined contact pads on the printed circuit board.

United States patent 3.689.865 discloses a connector having a first side connected to several coaxial cables and a second side into which a printed circuit board or the like can inserted. The connector comprises a plurality of inner contact members being soldered to respective inner conductors of the coaxial cables and to respective metallic pads on a small internal printed circuit board. The inner contact members are arranged to establish electrical contact to contact pads on a predetermined side of the printed circuit board or the like. One outer contact member is provided to establish good electrical contact to a ground plane on the opposite side of the printed circuit board or the like. The one outer contact member is soldered to the small internal printed circuit board through a foil layer at its rear side. Moreover, the outer conductors of all coaxial cables are electrically connected to the second contact member.

A connector module generally comprises a housing of electrically insulative material which accommodates a plurality of contact elements or terminals arranged in rows and columns. The contact elements have a base section and a contact end and connecting end extending from opposite ends of the base section. The connecting ends project outside one side of the housing and are connected to a printed circuit board.

There have long been attempts to accommodate electronic circuits in as modular a design as possible on printed circuit boards of standard dimensions. The interconnections between the individual modules and components, such as recorders, playback devices, etc., are preferably made via electronic connectors. As a consequence of miniaturization and due to the high density of present day integrated circuits, a large number of electronic components can be mounted on a printed circuit board so that a large number of functions can be carried out by a module of this type. The number of terminals needed for connection to other modules has, likewise, increased.

As a result, there is a great need for connectors with a high contact element density, i.e., with a large number of electrical contacts or terminals per unit of volume. The need for connectors with high contact element density has become even greater as a result of the advent of surface mounting technology whereby electronic components are surface mounted to the printed circuit board. Surface mounted devices (SMD) are not mounted on a printed circuit board via the usual pinhole connection but are connected directly to the surface of the printed circuit itself. By surface mounting techniques, it is possible to mount electronic components readily on either surface of a board without interfering with connecting pins which project through the board. This results in a component density which is even higher than that achieved with conventional pinhole connections and a further increase in the number of terminals.

The object of the present invention is to provide a coaxial connector of a type defined in the preamble of claim 1 which is able to contact at least one contact pad on a predetermined side of a printed circuit board by its at least one innermost contact socket or pin and to contact the opposite side of the printed circuit board by the at least one outermost contact socket by a surface mounting technique.

Therefore, the coaxial connector according to the present invention is characterized in that said outer connecting portion and said inner connecting portion are arranged to contact opposite sides of said printed circuit board by a surface mounting technique, said outer connecting portion being integrally made with said outermost contact socket and said inner connecting portion being integrally made with said innermost contact socket or pin. Connectors designed in this manner possess sufficient mechanical stability and a sufficiently large contact surface so that reliable and mechanically stable connections with a printed circuit board can be made by surface mounting technique.

In a preferred embodiment the coaxial connector according to the invention is characterized in that the outer connecting portion of the outermost contact socket is a substantially half-cylindrical portion of said outermost contact socket extending outside the housing and the inner connecting portion of the innermost contact socket or pin is a connecting tongue. Such a connector can be easily manufactured from existing coaxial connectors by removing a part of the connecting end of the outermost contact socket from the circumference, and by removing part of the jacket of the innermost contact socket or pin.

Several coaxial connectors according to the invention can be accommodated in a single module housing.

In a further embodiment of the invention such a connector module housing may comprise at least one power connector, the latter comprising at least one contact socket or contact pin, surrounded by a housing, with an elongated connecting portion of electrically conducting material for connecting the power connector to a printed circuit board, said connecting portion being provided with a slot-shaped opening in which the printed circuit board can be received for connecting the power connector to one or both flat sides of said board by a surface mounting technique.

In this application, the term "printed circuit board", which is also commonly referred to as "printing wiring board", is understood as meaning, in general, substrates with conducting tracks and thus, for example, also substrates of liquid crystal displays.

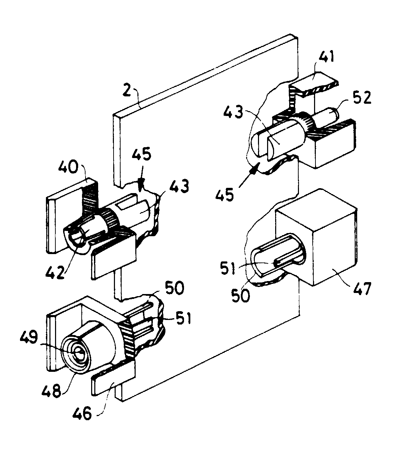

In the text which follows, the invention will be illustrated by reference to a single drawing of a preferred embodiment of a coaxial connector for surface mounting technique.

The single figure shows diagrammatically in perspective power and coaxial connectors connected surface mounted to a printed wiring board.

The figure shows diagrammatically in perspective and in partially cut-away view, power connectors 40, 41 and coaxial connectors 46, 47 for connecting by surface mounting feed cables and coaxial cables to a printed circuit board. Connectors described in the parent European patent application 0,393,251 are less suitable for connecting feed cables carrying a relatively large current.

The unipolar power connector 40 is essentially constructed from a contact socket 42 of electrically conducting material having a spring-loaded contact end for receiving a contact pin and an elongated socket-shaped connecting end 43 for connection to a printed wiring board. The power connector 41 has a pin-shaped contact end 52 and a similar socket-shaped connecting end 43. In order to make it possible to connect the connecting end to a printed circuit board by surface mounting, the elongate connecting end 43 is provided, according to the invention, with a slot-shaped recess 45 in which the printed circuit board 2 may be received so that the connecting end 43 can be connected to the printed circuit board 2 at the two opposite flat sides thereof.

For connecting coaxial plugs, coaxial connectors 46, 47 are used in practice. These connectors have an elongated outermost contact socket 48 and innermost contact socket 49 which are electrically insulated from each other and respectively an outermost contact socket and an innermost contact pin (not shown) of electrically conducting material.

To permit surface mounting of the coaxial connectors to a printed circuit board, a part of the connecting end of the outermost contact socket 48 is removed from the circumference so that the remaining, virtually semicylindrical connecting end 50 can be connected to one side of the printed circuit board 2. Part of the jacket of the innermost contact socket 49, or the innermost contact pin, is removed so that the remaining connecting tongue 51 can be connected to the other side of the printed circuit board 2.

The connectors designed in this manner possess sufficient mechanical stability and a sufficiently large contact surface so that reliable and mechanically stable connections with a printed circuit board can be made by surface mounting technique. In practice, of course, it is possible, as a departure from the embodiments shown in the figure, for several coaxial connectors and/or several power connectors to be accommodated in a single module housing.

It will be clear that the invention is not limited to the preferred embodiment thereof described and shown in the drawing, but that other variations and modifications are possible. For example, the connector modules may include optoelectronic connectors connected to optical fiber cables, shielded connectors, to locking means or so called polarity indicators to prevent incorrect connection of the connector modules, etc., all without deviating from the scope of the invention which is defined by the claims.

## Claims

1. A coaxial connector comprising at least one outermost (48) and one innermost contact socket or pin (49), mutually electrically insulated and surrounded by a housing, and having connecting portions of electrically conducting material for connecting the coaxial connector to a printed circuit board (2), the outermost contact socket (48) being electrically connected to an outer connecting portion (50) for connecting it to said printed circuit board and the innermost contact socket or pin (49) having an inner connecting portion (51) for connecting it to said printed circuit board characterized in that said outer connecting portion (48) and said inner connecting portion (49) are arranged to contact opposite sides of said printed circuit board by a surface mounting technique, said outer connecting portion (50) being integrally made with said outermost contact socket (48) and said inner connecting portion (51) being integrally made with said innermost contact socket or pin (49).

2. A coaxial connector according to claim 1 characterized in that the outer connecting portion (50) of the outermost contact socket is a substantially half-cylindrical portion of said outermost contact socket extending outside the housing and the inner connecting portion (51) of the innermost contact socket or pin (49) is a connecting tongue.

3. A connector module housing comprising several coaxial connectors according to claim 1 or 2.

4. A connector module housing according to claim 3 furthermore comprising at least one power connector (40; 41), the latter comprising at least one contact socket or contact pin (42; 52), surrounded by a housing, with an elongated connecting portion (43) of electrically conducting material for connecting the power connector to a printed circuit board (2), said connecting portion being provided with a slot-shaped opening (45) in which the printed circuit board can be received for connecting the power connector to one or both flat sides of said board by a surface mounting technique.

## Patentansprüche

1. Koaxialverbinder, umfassend mindestens eine äußerste (48) und eine innerste Kontaktbuchse oder -stifteinrichtung (49), die gegenseitig elektrisch isoliert sind und von einem Gehäuse umgeben sind, und mit Verbindungsteilen aus elektrisch leitfähigem Material zum Verbinden des Koaxialverbinders mit einer Leiterplatte (2), wobei die äußerste Kontaktbuchse (48) mit einem äußeren Verbindungsteil (50) elektrisch verbunden ist, um sie mit der Leiterplatte zu verbinden, und die innerste Kontaktbuchse oder -stifteinrichtung (49) einen inneren Verbindungsteil (51) aufweist, um sie mit der Leiterplatte zu verbinden, dadurch gekennzeichnet, daß der äußere Verbindungsteil (48) und der innere Verbindungteil (49) so angeordnet sind, daß sie durch eine Oberflächenmontagetechnik mit entgegengesetzten Seiten der Leiterplatte in Kontakt treten, wobei der äußere Verbindungsteil (50) einteilig mit der äußersten Kontaktbuchse (48) und der innere Verbindungteil (51) einteiligmit der innersten Kontaktbuchse oder -stifteinrichtung (49) hergestellt ist.

2. Koaxialverbinder nach Anspruch 1, dadurch gekennzeichnet, daß der äußere Verbindungsteil (50) der äußersten Kontaktbuchse ein im wesentlichen halbzylindrischer Teil der äußersten Kontaktbuchse ist, der sich außerhalb des Gehäuses erstreckt, und der innere Verbindungsteil (51) der innersten Kontaktbuchse oder -stifteinrichtung (49) eine Verbindungszunge ist.

3. Verbindermodulgehäuse, umfassend mehrere Koaxialverbinder nach Anspruch 1 oder 2.

4. Verbindermodulgehäuse nach Anspruch 3, weiter umfassend mindestens einen Stromversorgungsverbinder (40; 41), wobei der letztere mindestens eine von einem Gehäuse umgebene Kontaktbuchse oder Kontaktstifteinrichtung (42; 52) mit einem länglichen Verbindungsteil (43) aus elektrisch leitfähigem Material zum Verbinden des Stromversorgungsverbinders mit einer Leiterplatte (2) umfaßt, wobei der Verbindungsteil mit einer schlitzförmigen Öffnung (45) versehen ist, in welcher die Leiterplatte aufgenommen werden kann, um den Stromversorgungsverbinder durch eine Oberflächenmontagetechnik mit einer oder beiden flachen Seiten der Platte zu verbinden.

## Revendications

1. Un connecteur coaxial comprenant au moins une douille ou broche de contact la plus extérieure (48) et une douille ou broche de contact la plus intérieure (49), mutuellement isolées électriquement et entourées par un boîtier, et présentant des parties de connexion en matériau électriquement conducteur pour relier le connecteur coaxial à une carte de circuit imprimé (2), la douille de contact la plus extérieure (48) étant électriquement connectée à une partie de connexion extérieure (50) pour la relier à ladite carte de circuit imprimé, et la douille ou broche de contact la plus intérieure (49) présentant une partie intérieure de connexion (51) pour la relier à ladite carte de circuit imprimé, caractérisé en ce que ladite partie de connexion extérieure (48) et ladite partie de connexion intérieure (49) sont agencées pour venir en contact avec des faces opposées de ladite carte de circuit imprimé par une technique de montage en surface, ladite partie de connexion extérieure (50) étant réalisée monobloc avec ladite douille de contact la plus extérieure (48), et ladite partie de connexion intérieure (51) étant réalisée monobloc avec ladite douille ou broche de contact (49) la plus intérieure.

2. Un connecteur coaxial selon la revendication 1, caractérisé en ce que la partie de connexion extérieure (50) de la douille de contact la plus extérieure est une partie sensiblement semi-cylindrique de ladite douille de contact la plus extérieure s'étendant à l'extérieur du boîtier et la partie de connexion intérieure (51) de la douille ou broche de contact (49) la plus intérieure est une languette de connexion.

3. Un boîtier pour module de connecteur comprenant plusieurs connecteurs coaxiaux selon la revendication 1 ou 2.

4. Un boîtier pour module de connecteur selon la revendication 3 comprenant de plus au moins un connecteur d'alimentation (40, 41), ce dernier comprenant au moins une douille de contact ou broche de contact (42; 52), entourée par un boîtier, avec une partie de connexion (43) allongée en matériau électriquement conducteur pour connecter le connecteur d'alimentation à une carte de circuit imprimé (2), ladite partie de connexion étant munie d'une ouverture (45) en forme de fente dans laquelle la carte de circuit imprimé peut être reçue pour relier le connecteur d'alimentation à l'une ou aux deux faces planes de ladite carte par une technique de montage en surface.
